# EUROPÄISCHE PATENTSCHRIFT

(11) **EP 3 178 301 B1**
(45) Veröffentlichungstag und Bekanntmachung des Hinweises auf die Patenterteilung: **24.10.2018**
(21) Anmeldenummer: 15750332.7
(22) Anmeldetag: 05.08.2015
(51) Int. Cl.: G01D 21/00, H05K 7/14

(54) **FELDGERÄT DER AUTOMATISIERUNGSTECHNIK**
AUTOMATION FIELD DEVICE
APPAREIL DE TERRAIN DE LA TECHNIQUE D'AUTOMATISATION

(30) Priorität: 08.08.2014 DE 102014111375
(43) Veröffentlichungstag der Anmeldung: 14.06.2017
(73) Patentinhaber: Endress+Hauser SE+Co. KG, 79689 Maulburg (DE)
(72) Erfinder: GROZINGER, Roland, 79395 Neuenburg (DE); KAISER, Andreas, 79674 Todtnau (DE); SPANKE, Dietmar, 79585 Steinen (DE)
(74) Vertreter: Andres, Angelika Maria
(86) Internationale Anmeldenummer: PCT/EP2015/068114
(87) Internationale Veröffentlichungsnummer: WO 2016/020460

(56) Entgegenhaltungen:
- DE-A1-102012 108 414
- US-A1- 2011 317 390

## Beschreibung

Die Erfindung bezieht sich auf ein Feldgerät der Automatisierungstechnik.

In der Automatisierungstechnik, insbesondere in der Prozessautomatisierungstechnik werden vielfach Feldgeräte eingesetzt, die zur Erfassung und/oder Beeinflussung von Prozessvariablen dienen. Zur Erfassung von Prozessvariablen dienen Sensoren, wie beispielsweise Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessvariablen Füllstand, Durchfluss, Druck, Temperatur, pH-Wert bzw. Leitfähigkeit erfassen. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden im Prinzip alle Geräte bezeichnet, die prozessnah eingesetzt werden und die prozessrelevante Informationen liefern oder verarbeiten. Im Zusammenhang mit der Erfindung werden unter Feldgeräten also insbesondere auch Remote I/Os, Funkadapter bzw. allgemein Geräte verstanden, die auf der Feldebene angeordnet sind. Eine Vielzahl solcher Feldgeräte wird von der Firma Endress + Hauser hergestellt und vertrieben.

Eine Gemeinsamkeit aller der oben erwähnten Feldgeräte ist, dass aus den durch die Sensoren ermittelten Prozessgrößen mittels einer nachgeschalteten Feldgeräteelektronik ein Messwert ermittelt und ausgewertet wird. Diese Feldgeräteelektronik ist meist auf die entsprechende Messanforderung und zu messende Prozessgröße angepasst, sodass für jedes Sensorprinzip, für jede zu messende Prozessgröße und für jede Messperformance eine eigenständige Feldgeräteelektronik entwickelt werden muss. Gleiches gilt natürlich auch in dem Fall, dass das Feldgerät ein Aktor aufweist und zum Beeinflussen der Prozessgröße dient. Heutzutage werden Funktionen in einzelnen Elektronikmodulen gekapselt, die typischerweise eine Mehrzahl an Schnittstellen aufweisen. Einer dieser Schnittstellen dient beim Einsatz des Feldgerätes zur Anbindung einer externen Einheit, die für die gewünschte Funktion notwendig ist. Die Schnittstelle stellt somit quasi eine "Kundenschnittstelle" dar, die individuell von Feldgerät zu Feldgerät belegt werden kann. Neben der "Kundenschnittstelle" weisen die heutigen Elektronikmodule eine interne Schnittstelle auf, über die die Funktion innerhalb des Feldgerätes zur Verfügung gestellt wird. Typischerweise sind die Schnittstellen so angeordnet, dass die "Kundenschnittstelle" vorne für den Kunden zugänglich liegt und die interne Schnittstelle hinten ausgeführt ist. Nachteilig bei dieser Lösung ist, dass beim Vergießen der Leiterplatte in dem Gehäuse des Elektronikmodules aufwendige Abdichtungsmaßnahmen getroffen werden müssen, damit der Verguß nicht aus dem Gehäuse läuft.

In der DE 10 2012 108 414 A1 ist ein Feldgerät beschrieben, das ein Gehäuse zur Aufnahme elektronischer Komponenten umfasst. Dieses Gehäuse umfasst eine erste Kammer, in der elektronische Komponenten angeordnet sind, und eine zweite Kammer, in der auf einer Leiterplatte angeordnete Benutzerschnittstellen der elektronischen Komponenten und/oder Anschlusselemente vorgesehen sind. Ein Ende der Leiterplatte ragt durch eine verklebte Durchführung hindurch in die erste Kammer hinein, wo es elektromechanisch von einer Steckeinrichtung aufgenommen wird, mit der auch die in der ersten Kammer angeordneten Komponenten verbunden sind.

In der US 2011/0317390 A1 ist ein Gehäuse für ein Feldgerät beschrieben, das durch einen in das Gehäuse eingesetzten Zwischenboden in eine erste und eine durch einen Gehäusedeckel nach außen abgeschlossene zweite Kammer unterteilt ist. In der ersten Kammer sind als Module ausgebildete elektronische Komponenten angeordnet, die über im Zwischenboden vorgesehene Durchführungen mit zugehörigen, in der zweiten Kammer angeordneten elektronischen Komponenten oder Anschlusselementen verbunden sind und über durch eine die zweite Kammer außenseitlich umgebende Außenwand des Gehäuse hindurch verlaufende Durchführungen hindurch von außen kontaktiert werden können.

Der Aufbau der in der DE 10 2012 108 414 A1 und der US 2011/0317390 A1 beschriebenen Feldgeräte ist aufgrund der beiden voneinander getrennten Gehäusekammern vergleichsweise aufwendig und nicht ohne weiteres an geänderte Anforderungen anpassbar. Insb. kann z.B. ein Austausch einer der in der ersten Kammer angeordneten elektronischen Komponenten einen Austausch oder zumindest Abwandlungen der zugehörigen in der zweiten Kammer angeordneten Benutzerschnittstelle und/oder der zugehörigen Anschlusselemente, sowie ggfs. sogar der in Verbindung mit den jeweiligen Komponenten vorgesehenen Durchführungen erforderlich machen.
Der Erfindung liegt die Aufgabe zugrunde, ein Feldgerät vorzuschlagen, dessen Funktionalität sich durch eine Feldgeräteelektronik entsprechend den Anforderungen einfach anpassen lässt und sich einfacher herstellen lässt.

Die Aufgabe wird erfindungsgemäß durch ein Feldgerät der Automatisierungstechnik mit einem Gehäuse und einer innerhalb des Gehäuses befindlichen modular aufgebauten Feldgeräteelektronik gelöst, wobei das Feldgerät wenigstens folgendes umfasst:
- eine erste Leiterplatte mit zumindest einem ersten und einem zweiten Steckverbinderelement, wobei das erste und zweite Steckverbinderelement zur Übertragung von Energie und/oder Daten ausgebildet sind, so dass ein damit komplementäres Steckverbinderelement, das ebenfalls zur Übertragung von Energie und/oder Daten ausgebildet ist, über eine Vorzugssteckrichtung ansteckbar ist, und so die beiden Steckverbinderelemente eine Steckverbinder-Kupplung bilden, wobei das erste Steckverbinderelement zum elektrischen Anschluss einer Peripherieeinheit dient, wobei das erste Steckverbinderelement und das zweite Steckverbinderelement derartig auf der ersten Leiterplatte angeordnet sind, dass sowohl das erste als auch das zweite Steckverbinderelement im Wesentlichen von derselben Vorzugssteckrichtung aus kontaktierbar ist,
- eine zweite Leiterplatte mit zumindest einem dritten Steckverbinderelement, das zur Übertragung von Energie und/oder Daten ausgestaltet und komplementär zum zweiten Steckverbinderelement ist, wobei die Leiterplatten so angeordnet sind, dass das zweite Steckverbinderelement lösbar mit dem dritten Steckverbinderelement der zweiten Leiterplatte verbunden ist, um so die Peripherieeinheit elektrisch an die zweite Leiterplatte mit Hilfe der ersten Leiterplatte anzubinden, und die zweite Leiterplatte zumindest eine Aussparung aufweist, über die das erste Steckverbinderelement der ersten Leiterplatte zum Anschluss der Peripherieeinheit zugänglich ist.

Erfindungsgemäß wird die Aufgabe dadurch gelöst, dass die Trennung der Schnittstellen nicht zwischen hinten und vorne erfolgt, sondern, dass die beiden Schnittstellen vorne verbleiben. Sämtliche Schnittstellen der jeweiligen Leiterplatte zeigen also in dieselbe Richtung und sind über dieselbe Vorzugssteckrichtung aus kontaktierbar, also ineinander steckbar.

Die Steckverbinderelemente sind so ausgebildet, dass sie jeweils an ein entsprechendes, d.h. gegensätzlich ausgebildetes, Steckverbinderelement lösbar ansteckbar sind. Die beiden gegensätzlich ausgebildeten Steckverbinderelemente werden dabei gemäß ihrer Vorzugssteckrichtung ineinander gesteckt und durch Formschluss mechanisch passend ausgerichtet und bilden somit eine Steckverbinder-Kupplung. Die Vorzugssteckrichtung kann hierbei als ein Normalenvektor verstanden werden, der auf der zu dem jeweiligen Steckverbinderelement weisenden Stirnfläche steht.

Eine vorteilhafte Ausgestaltung sieht vor, dass die erste Leiterplatte ein viertes Steckverbinderelement aufweist, das zur Übertragung von Energie und/oder Daten ausgestaltet ist, und von derselben Vorzugssteckrichtung wie das erste und zweite Steckverbinderelement aus kontaktierbar ist.

Insbesondere sieht die Ausgestaltung vor, dass das vierte Steckverbinderelement über zumindest eine Gasentladungsröhre bzw. Gasableiter mit dem ersten Steckverbinderelement verbunden ist.

Eine weitere vorteilhafte Ausgestaltung sieht vor, dass die zweite Leiterplatte zumindest ein fünftes Steckverbinderelement aufweist, das zur Übertragung von Energie und/oder Daten ausgebildet ist und zum vierten

Steckverbinderelement der ersten Leiterplatte komplementär ist, wobei das fünfte Steckverbinderelement auf der gleichen Leiterplattenseite wie das dritte Steckverbinderelement der zweiten Leiterplatte angeordnet ist, und wobei eine Vielzahl, vorzugsweise alle, Kontaktstifte des fünfte Steckverbinderelement mit Masse verbunden sind.

Eine weitere vorteilhafte Ausgestaltung sieht vor, dass die zweite Leiterplatte weitere dritte Steckverbinderelemente aufweist, die zur Übertragung von Energie und/oder Daten ausgebildet sind und zum zweiten Steckverbinderelement der ersten Leiterplatte komplementär sind.

Insbesondere sieht die Ausgestaltung vor, dass in dem Fall, dass weitere erste Leiterplatten über die weiteren dritten Steckverbinderelemente an die zweite Leiterplatte angesteckt werden, die zweite Leiterplatte weitere Aussparungen aufweist, über die die ersten Steckverbinderelemente der weiteren ersten Leiterplatten zum Anschluss weiterer Peripherieeinheiten zugänglich sind. Ferner sieht die Ausgestaltung vor, dass alle dritten Steckverbinderelemente über einen internen Bus miteinander verbunden sind. Besonders bevorzugt sieht die Ausgestaltung vor, dass das zweite Steckverbinderelement der ersten Leiterplatte gemäß einer Busspezifikation, vorzugsweise einer CAN-Busspezifikation, ausgebildet ist.

Eine weitere vorteilhafte Ausgestaltung sieht vor, dass die zweite Leiterplatte weitere fünfte Steckverbinderelemente aufweist, die zur Übertragung von Energie und/oder Daten ausgebildet sind und wobei eine Vielzahl, vorzugsweise alle, Kontaktstifte der weiteren fünften Steckverbinderelemente ebenfalls mit Masse verbunden sind.

Eine weitere vorteilhafte Ausgestaltung sieht vor, dass alle dritten Steckverbinderelemente und alle fünften Steckverbinderelemente in alternierender Reihenfolge auf der zweiten Leiterplatte angeordnet sind.

Eine weitere vorteilhafte Ausgestaltung sieht vor, dass die ersten, zweiten und vierten Steckverbinderelemente der ersten Leiterplatte von derselben Leiterplattenkante oder Leiterplattenseite aus kontaktierbar sind.

Eine weitere vorteilhafte Ausgestaltung sieht vor, dass die erste und zweite Leiterplatte derartig zueinander angeordnet sind, dass die Oberflächenebene der ersten Leiterplatte sich mit der Oberflächenebene der zweiten Leiterplatte schneidet.

Eine letzte Ausgestaltung sieht vor, dass die Peripherieeinheit räumlich außerhalb des Gehäuses angeordnet ist und in dem Gehäuse zumindest eine Öffnung oder eine Durchführung vorgesehen ist, durch die eine Leitung zu der Peripherieeinheit geführt ist.

Die Erfindung wird anhand der nachfolgenden Zeichnungen näher erläutert. Es zeigt:
- Fig. 1:: eine schematische Darstellung eines Feldgerätes,
- Fig. 2:: eine schematische Darstellung der ersten Leiterplatte, und
- Fig. 3:: eine schematische Darstellung der zweiten Leiterplatte.

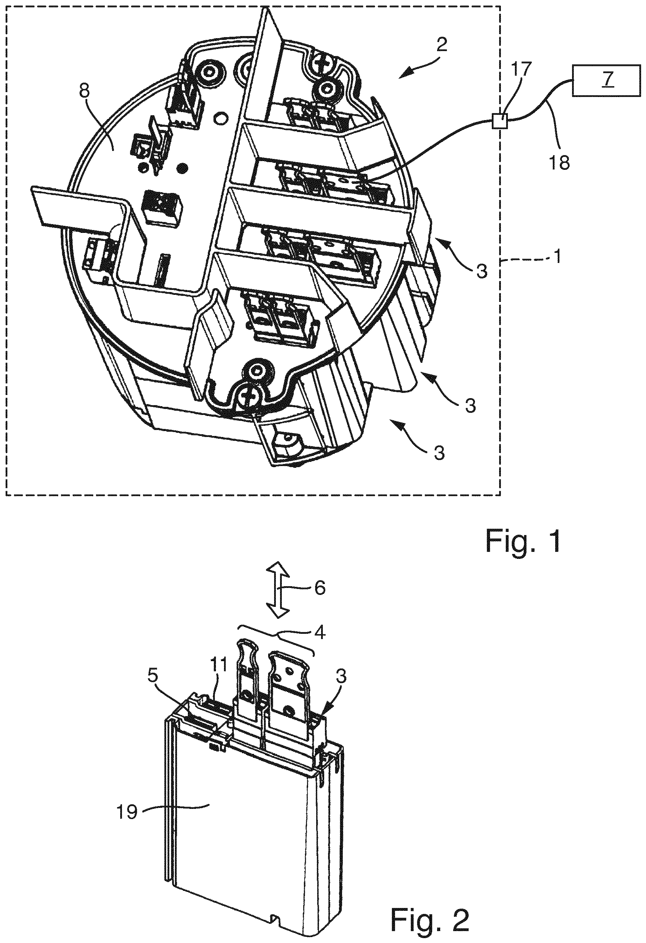

Figur 1 zeigt eine schematische Darstellung eines erfindungsgemäßen Feldgerätes der Automatisierungstechnik. Das erfindungsgemäße Feldgerät zeichnet sich dadurch aus, dass die innerhalb des Gehäuses 1 befindliche Feldgeräteelektronik 2 modular aus zumindest einer ersten Leiterplatte 3 und einer zweiten Leiterplatte 8 aufgebaut ist. Typischerweise dürfte jedoch die Feldgeräteelektronik 2 aus mehreren ersten Leiterplatten 3 bestehen, die über die zweite Leiterplatte 8, die quasi als Hauptplatine dient, miteinander verbunden sind. Die Leiterplatten 3, 8 sind dabei derartig aufgebaut, dass die zweite Leiterplatte 8, die als eine Hauptleiterplatte dient, durch Anstecken von der zumindest einen ersten Leiterplatte 3, in elektrischem Kontakt zur ersten Leiterplatte 3 steht, umso Daten und/oder Energie miteinander auszutauschen. Wie bereits gesagt, sind typischerweise mehrere erste Leiterplatten 3 mit der zweiten Leiterplatte 8 (Hauptleiterplatte) verbunden, sodass sich die gewünschte Funktion des Feldgerätes über eine individuell abgestimmte Feldgeräteelektronik 2 realisieren lässt. Die modulare Feldgeräteelektronik 2 entspricht somit dem Baukastenprinzip, bei dem das Gesamtsystem, also die Feldgeräteelektronik 2, aus Einzelbausteinen, also den verschiedenen Leiterplatten 3, 8, aufgebaut wird.

Die auf diese Weise aufgebaute bzw. zusammengesetzte Feldgeräteelektronik 2 ist anschließend in das Gehäuse 1 des Feldgerätes integriert. Das Gehäuse 1 des Feldgerätes ist in Fig. 1 über die gestrichelte Linie angedeutet. Das in Fig. 1 dargestellte Gehäuse 1 weist eine Öffnung bzw. eine Durchführung 17 auf, mittels derer eine sich außerhalb des Feldgerätgehäuses 1 befindliche Peripherieeinheit 7 über eine Leitung 18 an die Feldgeräteelektronik 2 anbinden bzw. anschließen lässt. Denkbar ist aber auch eine alternative Ausführung des Feldgerätes bei der sich die Peripherieeinheit 7 innerhalb des Gehäuses 1 befindet.

Als Peripherieeinheit 7 gelten ganz allgemein Einheiten, die über eine analoge oder eine digitale Schnittstelle drahtgebunden oder drahtlos eine Information erhalten oder zur Verfügung stellen.

Beispiele hierfür sind:
- eine SPS, welche die Informationen ausliest oder zur Verfügung stellt;
- ein Thermoelement, welches eine analoge Thermospannung erzeugt;
- ein Feldgerät, welches ein digitales Signal erzeugt, das z.B. beim Erreichen eines Grenzstandes generiert wird;
- ein Feldgerät, welches ein analoges Stromsignal mit oder ohne digitalem Kommunikationsanteil (HART) erzeugt;
- ein Empfangseinheit zum Empfang von drahtlosen digitalen Signalen (Wireless HART, etc.).

Fig. 2 zeigt eine schematische Darstellung einer Ausgestaltungsmöglichkeit der ersten Leiterplatte 3. Die erste Leiterplatte 3 weist in der vorliegenden Ausgestaltung ein erstes, ein zweites und ein viertes Steckverbinderelement 4, 5, 11 zur Übertragung von Daten und/oder Energie auf. Andere Ausgestaltungen, bei denen die Anzahl der vorhandenen Steckverbinderelemente von der, in Fig. 2 dargestellten Ausgestaltung abweicht, sind durchaus denkbar.

Die Steckverbinderelemente 4, 5, 11 weisen typischerweise eine Vielzahl von Kontaktstiften auf. Beispielsweise kann ein Steckverbinderelement aus zwei Reihen bestehen, die jeweils 12 Kontaktstifte umfassen und somit das Steckverbinderelement insgesamt 24 Kontaktstifte aufweist.
Die Steckverbinderelemente 4, 5, 11 sind so ausgebildet, dass sie jeweils an ein entsprechendes, d.h. gegensätzlich ausgebildetes, Steckverbinderelement 9, 13, 15, 16 lösbar ansteckbar sind. Die beiden gegensätzlich ausgebildeten Steckverbinderelemente werden dabei gemäß ihrer Vorzugssteckrichtung ineinander gesteckt und durch Formschluss mechanisch passend ausgerichtet und bilden somit eine Steckverbinder-Kupplung.
Die Vorzugssteckrichtung kann als ein Normalenvektor verstanden werden, der auf der zu dem jeweiligen Steckverbinderelement weisenden Stirnfläche steht. In Fig. 2 ist die Vorzugssteckrichtung durch den Pfeil mit Bezugszeichen 6 angedeutet.

Erfindungsgemäß sind alle Steckverbinderelemente 4, 5, 11 die sich auf der ersten Leiterplatte befinden derartig angeordnet, dass sie im Wesentlichen von derselben Vorzugssteckrichtung 6 aus kontaktierbar sind. So sind bspw., wie in Fig. 2 dargestellt, die Steckverbinderelemente 4, 5, 11 der ersten Leiterplatte 3 auf einer bzw. an einer Leiterplattenkante angeordnet und die Normalenvektoren sämtlicher Steckverbinderelemente 4, 5, 11 zeigen in dieselbe Richtung. Somit ist es möglich, alle Steckverbinderelemente 4, 5, 11 der ersten Leiterplatte 3 von der Vorzugssteckrichtung 6 aus zu kontaktieren. Ferner ergibt sich durch die Anordnung sämtlicher Steckverbinderelemente 4, 5, 11 entlang einer Leiterplattenkante der Vorteil, dass sich beim Vergießen der ersten Leiterpatte 3 in ein Leiterplattengehäuse 19 dieses Leiterplattengehäuse 19 nur an einer Seite eine Öffnung aufweisen muss, an der alle Steckverbinderelemente 4, 5, 11 der ersten Leiterplatte 3 herausragen. Bei den aus dem Stand der Technik bekannten Leiterplatten sind die Steckverbinderelemente an verschiedenen Leiterplattenkante angeordnet und beim Vergießen muss ein erheblicher Mehraufwand betrieben werden, um die Leiterplatte fachgerecht in dem mit mehreren Öffnungen versehene Leiterplattengehäuse abzudichten.

Die erste Leiterplatte 3 erfüllt eine spezifische Funktion. In dem Fall, dass mehrere erste Leiterplatten 3 vorgesehen sind, kann es zweckdienlich sein, dass jede der ersten Leiterplatten 3 eine andere spezifische Funktion erfüllt. Die in Fig. 2 dargestellte erste Leiterplatte, dient dem elektrischen Anbinden einer Peripherieeinheit 7. Hierzu ist die Peripherieeinheit 7 über eine Leitung 18 an das erste Steckverbinderelement 4 lösbar angeschlossen. Die erste Leiterplatte 3 dient somit dem Anbinden bzw. Anschließen von externen, d.h. außerhalb des Gehäuses des Feldgeräts 1 angeordneten Einheiten, wie sie weiter oben beschrieben sind, an die interne Feldgeräteelektronik 2.

Das zweite Steckverbinderelement 5 der ersten Leiterplatte 3 dient dazu, die erste Leiterplatte 3 elektrisch an die zweite Leiterplatte 8 anzubinden. Typischerweise ist hierfür das zweite Steckverbinderelement 5 gemäß einer Busspezifikation, bspw. einer CAN-Busspezifikation ausgebildet. Über das zweite Steckverbinderelement 5 wird die interne Kontaktierung der ersten und zweiten Leiterplatte 3, 8 zueinander realisiert.

Das vierte Steckverbinderelement 11 der ersten Leiterplatte 3 dient ebenfalls, wie die anderen Steckverbinderelemente 4, 5 auch, zur Übertragung von Energie und/oder Daten. Es ist ebenfalls, wie die anderen Steckverbinderelement 4, 5 auch, von derselben Vorzugssteckrichtung 6 aus kontaktierbar. Über die erste Leiterplatte 3 ist das vierte Steckverbinderelement 11 durch zumindest eine Gasentladungsröhre bzw. Gasableiter, in Fig. 2 nicht dargestellt, mit dem ersten Steckverbinderelement 4 verbunden.

Das vierte Steckverbinderelement 11 ist, genauso wie alle anderen Steckverbinderelemente 4, 5 auch, aus einer Vielzahl von einzelnen Kontaktstiften ausgebildet. Während bei den anderen Steckverbinderelementen 4, 5 die einzelnen Kontaktstifte individuell verschieden belegt sind, bspw. Pin 1 mit Masse, Pin 2 mit einer ersten Datenleitung, Pin 3 wieder mit Masse und Pin mit einer zweiten Datenleitung, etc., sind mehrere Kontaktstifte des vierten Steckverbinderelementes 11 mit Masse belegt, umso im Falle einer Überspannung, die von der extern angeordneten Peripherieeinheit 7 stammt, einen Strom über das erste Steckverbinderelement 4, die Gasentladungsröhre bzw. den Gasableiter und anschließend das vierte Steckverbinderelement 11 abzuleiten. Durch das Ableiten des Stromes, im Falle einer Überspannung, über eine Vielzahl von Pins des vierten Steckverbinderelementes 11 wird eine Zerstörung der Feldgeräteelektronik 2 verhindert.

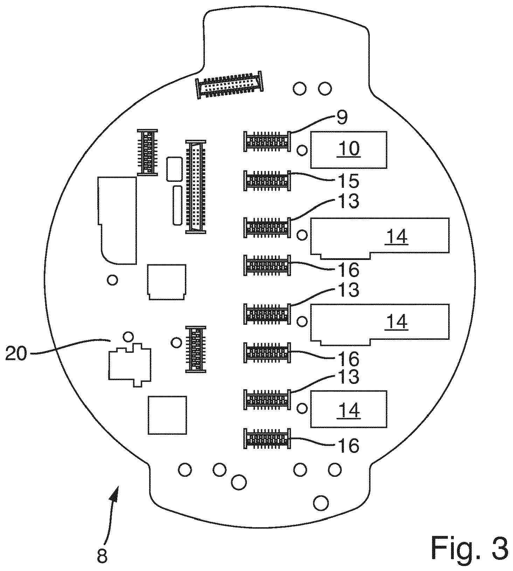

Fig. 3 zeigt eine schematische Darstellung der zweiten Leiterplatte 8, die als Hauptplatine der Feldgeräteelektronik 2 dient. Die zweite Leiterplatte 8 weist zumindest ein drittes Steckverbinderelement 9 auf. Typischerweise sind weitere dritte Steckverbinderelemente 13 vorhanden, die zur Übertragung von Daten und/oder Strom dienen. Sämtliche dritten Steckverbinderelemente 9, 13 sind dabei derartig auf der zweiten Leiterplatte 8 angeordnet, dass sie sich alle auf derselben einer ersten Seite 20 der zweiten Leiterplatte 8 befinden. Ihre Vorzugssteckrichtungen 6 weisen somit aus der Eben des Blattes hinaus bzw. ihr Normalenvektor steht auf der ersten Seite der zweiten Leiterplatte 20.
Die dritten Steckverbinderelemente 9, 13 dienen zur internen Kontaktierung der ersten Leiterplatte 3 mit der zweiten Leiterplatte 8. Wie bereits weiter oben beschrieben, sind die dritten Steckverbinderelemente 9, 13 komplementär, also gegensätzlich zum ersten Steckverbinderelement 4 ausgebildet, sodass sie ineinander steckbar sind. Zumindest ein Teil der dritten Steckverbinderelement 9, 13 sind auf der zweiten Leiterplatte 8 über einen Bus, bspw. einen CAN-Bus, miteinander verbunden.

Die zweite Leiterplatte 8 weist ferner zumindest eine Aussparungen 10 auf, durch die, wenn die erste Leiterplatte 3 mit der zweiten Leiterplatte 8 verbunden ist, das erste Steckverbinderelement 4 der ersten Leiterplatte 3 hinausragt, um eine Kontaktierung des ersten Steckverbinderelementes 4 zu ermöglichen. Wiederum weist die zweite Leiterplatte 8 typischerweise weitere Aussparungen 14 auf, durch die im Falle, dass mehrere erste Leiterplatten 3 mit der zweiten Leiterplatte 8 verbunden werden sollen, die ersten Steckverbinderelemente 4 der ersten Leiterplatten 3 durch diese Aussparungen bzw. Öffnungen kontaktierbar sind.

Neben den dritten Steckverbinderelementen 9, 13 weist die zweite Leiterplatte 8 zumindest ein fünftes Steckverbinderelement 15, typischerweise jedoch mehrere weitere fünfte Steckverbinderelemente 16, auf, die wiederum zur Übertragung von Energie und/oder Daten ausgebildet sind. Die Kontaktstifte der fünften Steckverbinderelemente 15, 16 sind gleich belegt, wie die Kontaktstifte der vierten Steckverbinderelemente 11, umso den Strom im Falle einer Überspannung ableiten zu können.

Die dritten Steckverbinderelemente 9, 13 und die fünften Steckverbinderelemente 15, 16 sind auf der zweiten Leiterplatte 8 in alternierender Reihenfolge angeordnet.

### Bezugszeichenliste

- 1: Gehäuse des Feldgerätes
- 2: Feldgeräteelektronik
- 3: Erste Leiterplatte
- 4: Erstes Steckverbinderelement zur externen Kontaktierung
- 5: Zweites Steckverbinderelement zur internen Kontaktierung
- 6: Vorzugssteckrichtung
- 7: Peripherieeinheit
- 8: Zweite Leiterplatte
- 9: Drittes Steckverbinderelement
- 10: Aussparung
- 11: Viertes Steckverbinderelement
- 12: Gasentladungsröhre
- 13: Weitere dritte Steckverbinderelemente
- 14: Weitere Aussparungen
- 15: Fünftes Steckverbinderelement
- 16: Weitere fünfte Steckverbinderelemente
- 17: Öffnung bzw. Durchführung
- 18: Leitung zur Peripherieeinheit
- 19: Leiterplattengehäuse
- 20: Erste Seite der zweiten Leiterplatte

## Patentansprüche

1. Feldgerät der Automatisierungstechnik mit einem Gehäuse (1) und einer innerhalb des Gehäuses (1) befindlichen modular aufgebauten Feldgeräteelektronik (2), die wenigstens folgendes umfasst:
- eine erste Leiterplatte (3) mit zumindest einem ersten (4) und einem zweiten (5) Steckverbinderelement, wobei das erste und zweite Steckverbinderelement (4, 5) zur Übertragung von Energie und/oder Daten ausgebildet sind, so dass ein damit komplementäres Steckverbinderelement, das ebenfalls zur Übertragung von Energie und/oder Daten ausgebildet ist, über eine Vorzugssteckrichtung ansteckbar ist, und so die beiden Steckverbinderelemente eine Steckverbinder-Kupplung bilden, wobei das erste Steckverbinderelement (4) zum elektrischen Anschluss einer Peripherieeinheit (7) dient, wobei das erste Steckverbinderelement (4) und das zweite Steckverbinderelement (5) derartig auf der ersten Leiterplatte (3) angeordnet sind, dass sowohl das erste als auch das zweite Steckverbinderelement (4, 5) im Wesentlichen von derselben Vorzugssteckrichtung (6) aus kontaktierbar ist,
- eine zweite Leiterplatte (8) mit zumindest einem dritten Steckverbinderelement (9), das zur Übertragung von Energie und/oder Daten ausgestaltet und komplementär zum zweiten Steckverbinderelement (5) ist, wobei die Leiterplatten (3, 8) so angeordnet sind, dass das zweite Steckverbinderelement (5) lösbar mit dem dritten Steckverbinderelement (9) der zweiten Leiterplatte (8) verbunden ist, um so die Peripherieeinheit (7) elektrisch an die zweite Leiterplatte (8) mit Hilfe der ersten Leiterplatte (3) anzubinden, und die zweite Leiterplatte (8) zumindest eine Aussparung (10) aufweist, über die das erste Steckverbinderelement (4) der ersten Leiterplatte (3) zum Anschluss der Peripherieeinheit (7) zugänglich ist.

2. Feldgerät nach Anspruch 1, wobei die erste Leiterplatte (3) ein viertes Steckverbinderelement (11) aufweist, das zur Übertragung von Energie und/oder Daten ausgestaltet ist, und von derselben Vorzugssteckrichtung (6) wie das erste und zweite Steckverbinderelement (4, 5) aus kontaktierbar ist.

3. Feldgerät nach Anspruch 2, wobei das vierte Steckverbinderelement (11) über zumindest eine Gasentladungsröhre bzw. Gasableiter (12) mit dem ersten Steckverbinderelement (4) verbunden ist.

4. Feldgerät nach einem oder mehreren der vorhergehenden Ansprüche, wobei die zweite Leiterplatte zumindest ein fünftes Steckverbinderelement (15) aufweist, das zur Übertragung von Energie und/oder Daten ausgebildet ist und zum vierten Steckverbinderelement (11) der ersten Leiterplatte (3) komplementär ist, wobei das fünfte Steckverbinderelement (15) auf der gleichen Leiterplattenseite wie das dritte Steckverbinderelement (9) der zweiten Leiterplatte (8) angeordnet ist, und wobei eine Vielzahl, vorzugsweise alle, Kontaktstifte des fünfte Steckverbinderelement (15) mit Masse verbunden sind.

5. Feldgerät nach einem oder mehreren der vorhergehenden Ansprüche, wobei die zweite Leiterplatte (8) weitere dritte Steckverbinderelemente (13) aufweist, die zur Übertragung von Energie und/oder Daten ausgebildet sind und zum zweiten Steckverbinderelement (5) der ersten Leiterplatte komplementär sind.

6. Feldgerät nach Anspruch 5, wobei die in dem Fall, dass weitere erste Leiterplatten (3) über die weiteren dritten Steckverbinderelemente (13) an die zweite Leiterplatte (8) angesteckt werden, die zweite Leiterplatte (8) weitere Aussparungen (14) aufweist, über die die ersten Steckverbinderelemente (4) der weiteren ersten Leiterplatten (3) zum Anschluss weiterer Peripherieeinheiten (7) zugänglich sind.

7. Feldgerät nach Anspruch 6, wobei alle dritten Steckverbinderelemente (9, 13) über einen internen Bus miteinander verbunden sind.

8. Feldgerät nach Anspruch 7, wobei das zweite Steckverbinderelement (5) der ersten Leiterplatte (3) gemäß einer Busspezifikation, vorzugsweise einer CAN-Busspezifikation, ausgebildet ist.

9. Feldgerät nach einem oder mehreren der vorhergehenden Ansprüche, wobei die zweite Leiterplatte (8) weitere fünfte Steckverbinderelemente (16) aufweist, die zur Übertragung von Energie und/oder Daten ausgebildet sind und wobei eine Vielzahl, vorzugsweise alle, Kontaktstifte der weiteren fünften Steckverbinderelemente (16) ebenfalls mit Masse verbunden sind.

10. Feldgerät nach einem oder mehreren der vorhergehenden Ansprüche, wobei alle dritten Steckverbinderelemente (9, 13) und alle fünften Steckverbinderelemente (15, 16) in alternierender Reihenfolge auf der zweiten Leiterplatte (8) angeordnet sind.

11. Feldgerät nach einem oder mehreren der vorhergehenden Ansprüche, wobei die ersten, zweiten und vierten Steckverbinderelemente (4, 5, 11) der ersten Leiterplatte (3) von derselben Leiterplattenkante oder Leiterplattenseite aus kontaktierbar sind.

12. Feldgerät nach einem oder mehreren der vorhergehenden Ansprüche, wobei die erste und zweite Leiterplatte (3, 8) derartig zueinander angeordnet sind, dass die Oberflächenebene der ersten Leiterplatte (3) sich mit der Oberflächenebene der zweiten Leiterplatte (8) schneidet.

13. Feldgerät nach einem oder mehreren der vorhergehenden Ansprüche, wobei die Peripherieeinheit (7) räumlich außerhalb des Gehäuses (1) angeordnet ist und in dem Gehäuse (1) zumindest eine Öffnung oder eine Durchführung (17) vorgesehen ist, durch die eine Leitung (18) zu der Peripherieeinheit (7) geführt ist.

## Claims

1. Automation technology field device with a housing (1) and modular field device electronics (2) located within the housing (1), said field device electronics comprising at least the following:
- a first printed circuit board (3) with at least a first (4) and a second (5) connector element, wherein the first and the second connector element (4, 5) is designed to transmit energy and/or data, such that a connector element that is complementary to it and is also designed to transmit energy and/or data can be connected via a preferential connection direction, and the two connector elements form in this way a connector coupling, wherein the first connector element (4) is used for the electrical connection of a peripheral unit, wherein the first connector element (4) and the second connector element (5) are arranged on the first printed circuit board (3) in such a way that both the first and the second connector element (4, 5) can be contacted essentially from the same preferential direction (6),
- a second printed circuit board (8) with at least a third connector element (9), which is designed to transmit energy and/or data and is complementary to the second connector element (5),
wherein the printed circuit boards (3, 8) are arranged in such a way that the second connector element (5) is connected in a detachable manner to the third connector element (9) of the second printed circuit board (8) in order to electrically connect in this way the peripheral unit (7) to the second printed circuit board (8) with the help of the first printed circuit board (3), and the second printed circuit board (8) has at least a recess (10) via which the first connector element (4) of the first printed circuit board (3) can be accessed to connect the peripheral unit (7).

2. Field device as claimed in Claim 1, wherein the first printed circuit board (3) has a fourth connector element (11), which is designed to transmit energy and/or data, and can be contacted from the same preferential direction (6) as the first and second connector element (4, 5).

3. Field device as claimed in Claim 2, wherein the fourth connector element (11) is connected to the first connector element (4) via at least a gas discharge tube (12).

4. Field device as claimed in one or more of the previous claims, wherein the second printed circuit board has at least a fifth connector element (15), which is designed to transmit energy and/or data and is complementary to the fourth connector element (11) of the first printed circuit board (3), wherein the fifth connector element (15) is arranged on the same printed circuit board side as the third connector element (9) of the second printed circuit board (8), and wherein multiple contact pins, preferably all the contact pins, of the fifth connector element (15) are connected to ground.

5. Field device as claimed in one or more of the previous claims, wherein the second printed circuit board (8) has additional third connector elements (13), which are designed to transmit energy and/or data and are complementary to the second connector element (5) of the first printed circuit board.

6. Field device as claimed in Claim 5, wherein in the case that additional printed circuit boards (3) are connected to the second printed circuit board (8) via the additional third connector elements (13), the second printed circuit board (8) has additional recesses (14) via which the first connector elements (4) of the additional first printed circuit boards (3) are accessible for the purpose of connecting additional peripheral units (7).

7. Field device as claimed in Claim 6, wherein all the third connector elements (9, 13) are interconnected via an internal bus.

8. Field device as claimed in Claim 7, wherein the second connector element (5) of the first printed circuit board (3) is designed according to a bus specification, preferably a CAN bus specification.

9. Field device as claimed in one or more of the previous claims, wherein the second printed circuit board (8) has additional fifth connector elements (16), which are designed to transmit energy and/or data and wherein a multitude of the contact pins, preferably all the contact pins, of the additional fifth connector elements (16) are also connected to ground.

10. Field device as claimed in one or more of the previous claims, wherein all the third connector elements (9, 13) and all the fifth connector elements (15, 16) are arranged in an alternating sequence on the second printed circuit board (8).

11. Field device as claimed in one or more of the previous claims, wherein the first, second and fourth connector elements (4, 5, 11) of the first printed circuit board (3) can be contacted from the same printed circuit board edge or printed circuit board side.

12. Field device as claimed in one or more of the previous claims, wherein the first and second printed circuit board (3, 8) are arranged in such a way in relation to one another that the surface plane of the first printed circuit board (3) intersects with the surface plane of the second printed circuit board (8).

13. Field device as claimed in one or more of the previous claims, wherein the peripheral unit (7) is spatially arranged outside the housing (1) and wherein at least one opening or one passage (17) is provided in the housing (1) through which a cable (18) is guided to the peripheral unit (7).

## Revendications

1. Appareil de terrain de la technique d'automatisation avec un boîtier (1) et une électronique d'appareil de terrain (2) modulaire logée dans le boîtier (1), laquelle électronique comprend au moins les éléments suivants :
- une première carte de circuit imprimé (3) avec au moins un premier (4) et un deuxième (5) élément de connexion, le premier et le deuxième élément de connexion (4, 5) étant conçus pour la transmission de l'énergie et/ou des données de telle sorte qu'un élément de connexion complémentaire, qui est également conçu pour la transmission de l'énergie et/ou des données, puisse être enfiché par une direction d'enfichage préférentielle, et les deux éléments de connexion formant ainsi un couplage de connecteurs, le premier élément de connexion (4) servant au raccordement électrique d'une unité périphérique, le premier élément de connexion (4) et le deuxième élément de connexion (5) étant disposés sur la première carte de circuit imprimé (3) de telle sorte qu'à la fois le premier et le deuxième élément de connexion (4, 5) puissent être mis en contact pour l'essentiel selon la même direction d'enfichage préférentielle (6),
- une deuxième carte de circuit imprimé (8) avec au moins un troisième élément de connexion (9), qui est conçu pour la transmission de l'énergie et/ou des données et de façon complémentaire au deuxième élément de connexion (5), les cartes de circuit imprimé (3, 8) étant disposées de telle sorte que le deuxième élément de connexion (5) est relié de façon amovible avec le troisième élément de connexion (9) de la deuxième carte de circuit imprimé (8), afin de connecter ainsi l'unité périphérique (7) électriquement à la deuxième carte de circuit imprimé (8) à l'aide de la première carte de circuit imprimé (3), et la deuxième carte de circuit imprimé (8) comportant un évidement (10), par l'intermédiaire duquel le premier élément de connexion (4) de la première carte de circuit imprimé (3) est accessible pour le raccordement de l'unité périphérique (7).

2. Appareil de terrain selon la revendication 1, pour lequel la première carte de circuit imprimé (3) comporte un quatrième élément de connexion (11), qui est conçu pour la transmission de l'énergie et/ou des données, et qui peut être mis en contact à partir de la même direction d'enfichage préférentielle (6) que le premier et le deuxième élément de connexion (4, 5).

3. Appareil de terrain selon la revendication 2, pour lequel le quatrième élément de connexion (11) est relié par l'intermédiaire d'au moins un tube à décharge gazeuse ou d'un éclateur à gaz (12) avec le premier élément de connexion (4).

4. Appareil de terrain selon l'une ou plusieurs des revendications précédentes, pour lequel la deuxième carte de circuit imprimé comporte au moins un cinquième élément de connexion (15), qui est conçu pour la transmission d'énergie et/ou de données et est complémentaire par rapport au quatrième élément de connexion (11) de la première carte de circuit imprimé (3), le cinquième élément de connexion (15) étant disposé sur la même carte de circuit imprimé que le troisième élément de connexion (9) de la deuxième carte de circuit imprimé (8), et un grand nombre de broches de contact, de préférence toutes les broches, du cinquième élément de connexion (15), étant reliées avec la masse.

5. Appareil de terrain selon l'une ou plusieurs des revendications précédentes, pour lequel la deuxième carte de circuit imprimé (8) comporte des troisièmes éléments de connexion (13) supplémentaires, qui sont conçus pour la transmission de l'énergie et/ou des données, et sont complémentaires par rapport au deuxième élément de connexion (5) de la première carte de circuit imprimé.

6. Appareil de terrain selon la revendication 5, pour lequel dans le cas où des premières cartes de circuit imprimé (3) supplémentaires sont connectées par l'intermédiaire des troisièmes éléments de connexion (13) supplémentaires à la deuxième carte de circuit imprimé (8), la deuxième carte de circuit imprimé (8) comporte des évidements (14) supplémentaires, par l'intermédiaire desquels les premiers éléments de connexion (4) des premières cartes de circuit imprimé (3) supplémentaires sont accessibles pour le raccordement des unités périphériques (7) supplémentaires.

7. Appareil de terrain selon la revendication 6, pour lequel tous les troisièmes éléments de connexion (9, 13) sont reliés entre eux par l'intermédiaire d'un bus interne.

8. Appareil de terrain selon la revendication 7, pour lequel le deuxième élément de connexion (5) de la première carte de circuit imprimé (3) est conçu conformément à une spécification de bus, de préférence une spécification de bus CAN.

9. Appareil de terrain selon l'une ou plusieurs des revendications précédentes, pour lequel la deuxième carte de circuit imprimé (8) comporte des cinquièmes éléments de connexion (16) supplémentaires, qui sont conçus pour la transmission de l'énergie et/ou des données, et un grand nombre de broches de contact, de préférence toutes les broches, des cinquièmes éléments de connexion (15) supplémentaires étant également reliées avec la masse.

10. Appareil de terrain selon l'une ou plusieurs des revendications précédentes, pour lequel tous les troisièmes éléments de connexion (9, 13) et tous les cinquièmes éléments de connexion (15, 16) sont disposés en ordre alterné sur la deuxième carte de circuit imprimé (8).

11. Appareil de terrain selon l'une ou plusieurs des revendications précédentes, pour lequel les premiers, deuxièmes et quatrièmes éléments de connexion (4, 5, 11) de la première carte de circuit imprimé (3) peuvent être mis en contact à partir du même bord ou du même côté de la carte de circuit imprimé.

12. Appareil de terrain selon l'une ou plusieurs des revendications précédentes, pour lequel la première et la deuxième carte de circuit imprimé (3, 8) sont disposées l'une par rapport à l'autre de telle sorte que le plan de surface de la première carte de circuit imprimé (3) se coupe avec le plan de surface de la deuxième carte de circuit imprimé (8).

13. Appareil de terrain selon l'une ou plusieurs des revendications précédentes, pour lequel l'unité périphérique (7) est disposée à l'extérieur du boîtier (1) et
pour lequel est prévu dans le boîtier (1) au moins une ouverture ou un passage (17), à travers lequel/laquelle est acheminé un câble (18) vers l'unité périphérique (7).
